# EUROPÄISCHE PATENTSCHRIFT

(11) **EP 1 786 252 B1**
(45) Veröffentlichungstag und Bekanntmachung des Hinweises auf die Patenterteilung: **20.06.2012**
(21) Anmeldenummer: 06123389.6
(22) Anmeldetag: 02.11.2006
(51) Int. Cl.: H05K 7/14

(54) **Vorrichtung und Verfahren zum Einstecken und Ausziehen von Steckbaugruppen**
Device and method for inserting or removing a pluggable unit
Dispositif et méthode pour insérer ou extraire un module enfichable

(30) Priorität: 11.11.2005 EP 05405629
(43) Veröffentlichungstag der Anmeldung: 16.05.2007
(73) Patentinhaber: ELMA Electronic AG, 8620 Wetzikon (CH)
(72) Erfinder: Kari, Oila, 8038, Zürich (CH)
(74) Vertreter: Sulzer Management AG

(56) Entgegenhaltungen:
- DE-U1- 20 311 072
- JP-A- 1 164 098
- JP-A- 4 003 996
- US-A1- 2004 106 318

## Beschreibung

Die Erfindung betrifft eine Vorrichtung zum Einstecken und Ausziehen einer Steckbaugruppe mit Frontplatte in beziehungsweise aus einem Baugruppenträger gemäss Oberbegriff von Anspruch 1, eine Steckbaugruppe mit einer derartigen Vorrichtung und einen Baugruppenträger mit einer derartigen Steckbaugruppe sowie ein Verfahren zum Einstecken und Ausziehen einer Steckbaugruppe mit Frontplatte gemäss Anspruch 7.

In Baugruppenträger einführbare Steckbaugruppen weisen auf der Rückseite Mehrfachsteckverbindungen auf, deren Einsteck- und Ausziehkräfte beim Einstecken beziehungsweise Ausziehen der Steckbaugruppe überwunden werden müssen. Steckbaugruppen sind deshalb üblicherweise frontseitig mit einer oder mehreren Vorrichtungen versehen, beispielsweise je einer Vorrichtung in einem unteren und oberen Bereich der Frontseite, um das Einstecken und Ausziehen zu erleichtern. Die Vorrichtungen enthalten jeweils einen Hebelarm, der schwenkbar angeordnet und derart an einem frontseitigen Profil des Baugruppenträgers abgestützt ist, dass das Einstecken und Ausziehen durch die Wirkung des Hebelarms erleichtert wird. Weiter enthalten die Vorrichtungen jeweils eine Verriegelungseinrichtung, um den Hebelarm in eingeschwenkten Zustand zu verriegeln und/oder zu sichern, sowie bei Bedarf ein mittels Hebelarm oder Verriegelungseinrichtung betätigbares Schaltelement, um die Steckbaugruppe vor dem Ausziehen stromlos oder passiv zu schalten.

Aus Dokument DE 203 11 072 U1 ist eine Steckbaugruppe mit Frontplatte bekannt, in welcher an einem Hebelziehgriff ein Sperrhebel angelenkt ist, der eine Rastklinke umfasst, um den Hebelziehgriff in der eingeschwenkten Stellung zu sichern. Die Rastklinke ist mit einem auf der Leiterplatte der Steckbaugruppe angebrachten Schalter wirkverbunden, so dass die Steckbaugruppe beim Betätigen des Sperrhebels stromlos geschaltet werden kann. Nachteilig an dieser Steckbaugruppe ist die enge Anordnung der Griffteile von Hebelziehgriff und Sperrhebel unmittelbar beieinander, die es ermöglicht, beide Griffteile praktisch gleichzeitig zu betätigen. Dies führt bei schnellem Ausschwenken des Hebelziehgriffs dazu, dass der zeitliche Abstand zwischen dem Betätigen des Schalters und dem Trennen der rückseitigen Steckverbindungen beim Ausziehen der Steckbaugruppe sehr kurz sein kann, beispielsweise kürzer als 100 ms, und dass die Steckbaugruppe herausgezogen wird, bevor sich diese in passivem Zustand befindet. Je nach Anwendung der Steckbaugruppe können dabei die elektrischen Kontakte der rückseitigen Steckverbindungen und/oder die elektrische Schaltung der Steckbaugruppe oder damit verbundener Anlagenteile beschädigt werden. Ein weiterer Nachteil der oben beschriebenen Steckbaugruppe besteht darin, dass die enge Anordnung der Griffteile von Hebelziehgriff und Sperrhebel unmittelbar beieinander dazu verleitet, den Hebelziehgriff auszuschwenken, bevor die Rastklinke vollständig ausgeklinkt ist. Dies kann zu einer vorzeitigen Abnützung der Rastklinke führen.

Aufgabe der Erfindung ist es, eine Vorrichtung zum Einstecken und Ausziehen einer Steckbaugruppe mit Frontplatte in beziehungsweise aus einem Baugruppenträger, eine Steckbaugruppe mit einer derartigen Vorrichtung und einen Baugruppenträger mit einer derartigen Steckbaugruppe sowie ein Verfahren zum Einstecken und Ausziehen einer Steckbaugruppe mit Frontplatte zur Verfügung zu stellen, welche die oben genannten Nachteile aus dem Stand der Technik vermeidet.

Diese Aufgabe wird erfindungsgemäss durch die in Anspruch 1 definierte Vorrichtung zum Einstecken und Ausziehen einer Steckbaugruppe mit Frontplatte gelöst sowie durch das in Anspruch 7 definierte Verfahren, die in Anspruch 10 definierte Steckbaugruppe, und den in Anspruch 11 definierten Baugruppenträger.

Die erfindungsgemässe Vorrichtung zum Einstecken und Ausziehen einer Steckbaugruppe mit Frontplatte in beziehungsweise aus einem Baugruppenträger umfasst einen um eine Achse schwenkbaren Hebelarm mit einem Griffteil zum Schwenken des Hebelarms sowie ein Verriegelungselement zum Verriegeln des Hebelarms in eingeschwenktem Zustand und ein Betätigungselement zum Entriegeln desselben, das beispielsweise mit dem Verriegelungselement verbunden ist und mittels welchem der Hebelarm entriegelt werden kann. In der erfindungsgemässen Vorrichtung ist das Betätigungselement beabstandet vom Hebelarm angeordnet, und der Griffteil derart ausgestaltet, dass er im eingeschwenkten Zustand an der Frontplatte der Steckbaugruppe anliegt.

In einer bevorzugten Ausführungsform ist der Hebelarm nach dem Entriegeln in eine Zwischenposition schwenkbar, vorzugsweise selbsttätig in eine Zwischenposition schwenkbar.

In einer weiteren bevorzugten Ausführungsform umfasst die Vorrichtung ein Halteteil, z.B. zur Halterung des Verriegelungselementes und/oder Betätigungselementes und in einer weiteren bevorzugten Ausführungsform ein Schaltelement für eine Aktiv-Passiv-Schaltung und/oder Stromlos-Schaltung der Steckbaugruppe, das mittels des Verriegelungselementes und/oder Betätigungselementes betätigbar ist und das mit Vorteil am Halteteil befestigt ist. In einer bevorzugten Ausführungsvariante ist am Halteteil ein Zentrierstift zur Zentrierung der Steckbaugruppe beim Einstecken vorgesehen.

In einer weiteren bevorzugten Ausführungsvariante ist das Verriegelungselement selbsttätig einrastbar ausgebildet, um den Hebelarm im eingeschwenkten Zustand zu sichern, beispielsweise indem das Verriegelungselement mit einer Rückstellfeder wirkverbunden ist.

Weiter umfasst die Erfindung ein Verfahren zum Einstecken und Ausziehen einer Steckbaugruppe mit Frontplatte in beziehungsweise aus einem Baugruppenträger mittels einer Vorrichtung, die einen schwenkbaren Hebelarm mit Verriegelung enthält. Zum Ausziehen der Steckbaugruppe wird der eingeschwenkte und verriegelte Hebelarm mittels eines Betätigungselementes, das beabstandet vom Hebelarm angeordnet ist, entriegelt; der entriegelte Hebelarm selbsttätig in eine Zwischenposition ausgeschwenkt; und der Hebelarm mittels eines Griffteils desselben weiter ausgeschwenkt, wodurch die Steckbaugruppe herausgezogen wird; und zum Einstecken der Steckbaugruppe wird der Hebelarm mit dem Griffteil eingeschwenkt, bis der Griffteil an der Frontplatte anliegt; und der eingeschwenkte Hebelarm selbsttätig verriegelt.

In einer bevorzugten Ausführungsform wird das Einführen eines Fingers zwischen Griffteil und Frontplatte durch die Ausgestaltung des Griffteils und/oder das Anliegen des Griffteils an der Frontplatte erschwert oder verhindert.

In einer weiteren bevorzugten Ausführungsform wird beim Verriegeln und/oder beim Entriegeln des Hebelarms ein Schaltelement betätigt.

Weiter umfasst die Erfindung eine Steckbaugruppe mit Frontplatte, die mindestens eine der oben stehend beschriebenen Ausführungsformen einer Vorrichtung zum Einstecken und Ausziehen der Steckbaugruppe enthält, und/oder eine Steckbaugruppe mit Frontplatte zum Ausführen der oben stehend beschriebenen Verfahren, und/oder einen Baugruppenträger mit mindestens einer derartigen Steckbaugruppe.

Die erfindungsgemässe Vorrichtung und das erfindungsgemässe Verfahren zum Einstecken und Ausziehen einer Steckbaugruppe mit Frontplatte haben den Vorteil, dass der Entriegelungsvorgang vom Ausziehvorgang getrennt wird, da eine gleichzeitige Betätigung des Betätigungselementes zum Entriegeln und des Griffteils zum Ausschwenken des Hebelarms durch die beabstandete Anordnung des Betätigungselementes und die Ausgestaltung des Griffteils, der in eingeschwenktem Zustand an der Frontplatte anliegt oder in dieser versenkt ist, erschwert oder gar verhindert wird. Dies gilt insbesondere für Steckbaugruppen, die mit je einer Vorrichtung in einem unteren und oberen Bereich der Frontseite ausgestattet sind, und die nur ausgezogen werden können, wenn die Hebelarme der unteren und oberen Vorrichtung gleichzeitig ausgeschwenkt werden. D.h., dass eine Wartungsperson zum Ausziehen der Steckbaugruppe mit der linken und rechten Hand je eine Vorrichtung betätigen muss. Da die Griffteile in eingeschwenktem und verriegeltem Zustand des Hebelarms an der Frontplatte anliegen, wird eine Wartungsperson dazu angehalten, zunächst die Hebelarme zu entriegeln, wobei diese selbsttätig in eine Zwischenposition ausgeschwenkt werden. In der Zwischenposition können die Griffteile der Hebelarme anschliessend bequem gefasst und ausgeschwenkt werden. Ein Fassen der Griffteile zum Ausschwenken der Hebelarme, solange sich diese in eingeschwenktem Zustand befinden, wird durch das Anliegen der Griffteile an der Frontplatte und eine entsprechende Formgebung der Griffteile erschwert oder verhindert. Mit Vorteil sind die Griffteile derart ausgestaltet, dass das Einführen eines Fingers zwischen Griffteil und Frontplatte erschwert oder verhindert wird, solange die Griffteile an der Frontplatte anliegen. Dank der Trennung von Entriegelungsvorgang und Ausziehvorgang wird eine Beschädigung oder Abnützung der Verriegelungselemente durch Ausschwenken der Hebelarme, bevor diese vollständig entriegelt sind, weitgehend vermieden.

Vorteilhaft ist auch, dass bei Passiv-Schaltung der Steckbaugruppe der minimale zeitliche Abstand zwischen dem Betätigen des Schaltelementes beim Entriegeln und dem Trennen der rückseitigen Steckverbindungen beim Ausziehen der Steckbaugruppe dank der Trennung zwischen Entriegelungsvorgang und Ausziehvorgang verlängert werden kann.

Weiter vorteilhaft ist die Befestigung des Schaltelementes zum Aktiv-Passivbeziehungsweise Stromlos-Schalten der Steckbaugruppe an einem Halteteil der Vorrichtung zum Einstecken und Ausziehen derselben, da das Schaltelement in diesem Fall nicht separat auf einer Leiterplatte der Steckbaugruppe befestigt und/oder angelötet werden muss, sondern mittels Verbindungskabeln, insbesondere Verbindungskabeln mit Steckkontakten, mit der Leiterplatte verbunden werden kann. Mit Vorteil wird die Verbindung über Steckkontakte auf der Komponentenseite der Leiterplatte hergestellt. Das Einlöten der Steckkontakte auf der Leiterplatte kann zusammen mit dem Einlöten der übrigen Komponenten erfolgen, so dass der Aufwand für den Anschluss des Schaltelementes vergleichsweise gering ist.

Die obige Beschreibung von Ausführungsformen der erfindungsgemässen Vorrichtung und des erfindungsgemässen Verfahrens dienen lediglich als Beispiele. Weitere vorteilhafte Ausführungsformen gehen aus den abhängigen Ansprüchen und der Zeichnung hervor. Darüber hinaus können im Rahmen der vorliegenden Erfindung auch einzelne Merkmale aus den beschriebenen oder gezeigten Ausführungsformen miteinander kombiniert werden, um neue Ausführungsformen zu bilden.

Im Folgenden wird die Erfindung an Hand des Ausführungsbeispiels und an Hand der Zeichnung näher erläutert. Es zeigen:
- Fig. 1: eine Schrägansicht eines Ausschnitts aus einer Steckbaugruppe mit einem Ausführungsbeispiel einer Vorrichtung zum Einstecken und Ausziehen der Steckbaugruppe gemäss vorliegender Erfindung mit einem Hebelarm in eingeschwenktem Zustand,
- Fig. 2: das in Fig. 1 gezeigte Ausführungsbeispiel mit dem Hebelarm in einer Zwischenposition,
- Fig. 3a: eine Seitenansicht des Ausführungsbeispiels mit dem Hebelarm in eingeschwenktem Zustand,
- Fig. 3b: eine Seitenansicht des Ausführungsbeispiels mit dem Hebelarm in einer Zwischenposition, und
- Fig. 3c: eine Seitenansicht des Ausführungsbeispiels mit dem Hebelarm in ausgeschwenktem Zustand.

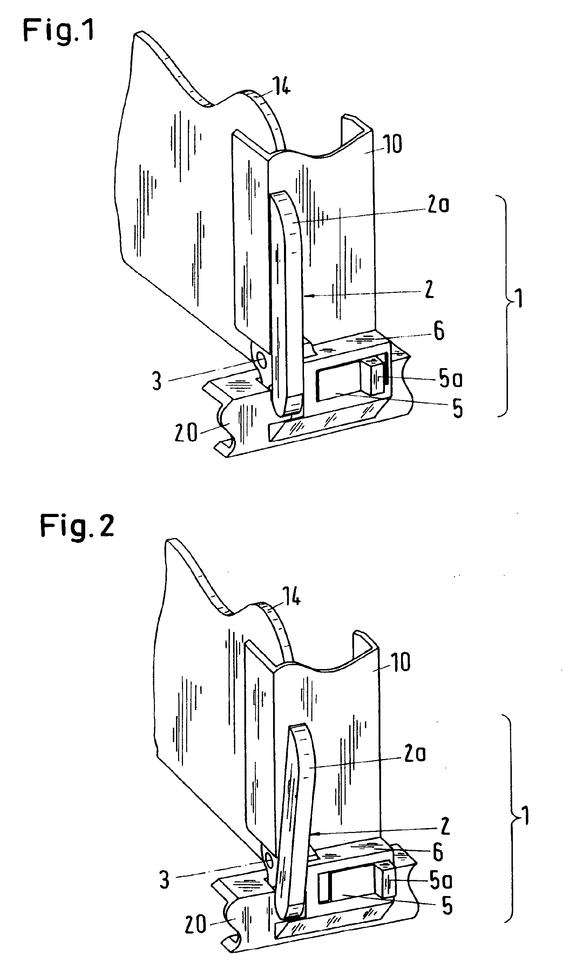

Fig. 1 zeigt eine Schrägansicht eines Ausschnitts aus einer Steckbaugruppe mit einem Ausführungsbeispiel einer Vorrichtung zum Einstecken und Ausziehen der Steckbaugruppe gemäss vorliegender Erfindung mit einem Hebelarm 2 in eingeschwenktem Zustand. Die gezeigte Steckbaugruppe umfasst neben der Vorrichtung 1 zum Einstecken und Ausziehen, ein Frontprofil 10, im Folgenden einfach Frontplatte genannt, und wahlweise eine Leiterplatte 14. Der Hebelarm 2 der Vorrichtung ist mit einem Griffteil 2a ausgestattet, mittels welchem der Hebelarm um eine Achse 3 geschwenkt werden kann. In dem in Fig. 1 gezeigten Ausführungsbeispiel dient ein Bereich an einem genügend weit, z.B. mehr als 1.5 cm, von der Achse entfernten Ende des Hebelarms als Griffteil. Selbstverständlich sind auch andere Formen des Griffteils möglich, solange dieser in eingeschwenktem Zustand an der Frontplatte anliegt. Beispielsweise kann eine andere als die gezeigte Form am Hebelarm ausgebildet oder angespritzt werden oder ein geeigneter Griffteil über das Ende des Hebelarms gestülpt werden. In einer weiteren Ausführungsvariante ist der Griffteil und die Frontplatte derart geformt, dass der Griffteil in eingeschwenktem Zustand des Hebelarms ganz oder teilweise in der Frontplatte versenkt ist.

Weiter umfasst die Vorrichtung des in Fig. 1 gezeigten Ausführungsbeispiels ein Verriegelungselement 5, das als einfacher Sperrriegel ausgebildet sein kann, der im eingeschwenkten Zustand des Hebelarms in diesen eingreift, um den Hebelarm zu verriegeln und/oder zu sichern. In einer vorteilhaften Ausführungsvariante ist das Verriegelungselement 5 vorgespannt, beispielsweise mittels einer Feder, so dass es im oder am Hebelarm 2 einrastet und diesen selbsttätig verriegelt, sobald sich der Hebelarm in eingeschwenktem Zustand befindet. Weiter umfasst die Vorrichtung ein Betätigungselement 5a zum Entriegeln des Hebelarms sowie bedarfsweise ein Halteteil 6 zur Halterung des Verriegelungselementes 5. Das Betätigungselement kann beispielsweise, wie in Fig. 1 gezeigt, als vorstehender Nocken am Verriegelungselement 5 ausgebildet sein, und das Verriegelungselement kann bewegbar im Halteteil 6 geführt sein. Zusätzlich kann das Betätigungselement 5a visuell hervorgehoben werden, beispielsweise durch eine entsprechende Farbgebung.

Fig. 1 zeigt weiter ein Frontprofil 20 eines Baugruppenträgers, in den die Steckbaugruppe eingesetzt ist. Die Vorrichtung 1 zum Einstecken und Ausziehen der Steckbaugruppe ist im unteren Bereich der Frontplatte 10 der Steckbaugruppe angeordnet, derart, dass in eingeschwenktem Zustand des zugehörigen Hebelarms 2 das Frontprofil 20 des Baugruppenträgers in eine Einbuchtung des Hebelarms eingreift, so dass die Steckbaugruppe ohne Ausschwenken desselben nicht herausgezogen werden kann. Der Hebelarm ist im eingeschwenkten Zustand mittels des Verriegelungselements 5 verriegelt, womit die Steckbaugruppe gegen unbeabsichtigtes Herausziehen oder ein Lockern und Herausgleiten unter Einfluss von Stössen oder Vibrationen gesichert ist.

Fig. 2 zeigt das unter Fig. 1 beschriebene Ausführungsbeispiel mit dem Hebelarm 2 in einer Zwischenposition. Die Bezugsnummern für die einzelnen Komponenten wurden beibehalten, so dass im Folgenden nur auf die Unterschiede zu Fig. 1 eingegangen wird. In Fig. 2 ist der Hebelarm 2 der Vorrichtung 1 zum Einstecken und Ausziehen der Steckbaugruppe entriegelt und in eine Zwischenposition ausgeschwenkt, beispielsweise um einen Winkel von 5° bis 20°, vorzugsweise, 8° bis 15° gegenüber dem eingeschwenkten Zustand. In der gezeigten Zwischenposition ist der Griffteil 2a des Hebelarms bequem zu fassen, so dass er anschliessend von Hand weiter ausgeschwenkt werden kann. Der entriegelte Zustand ist an der Position des Betätigungselementes 5a erkennbar, das in dem in Fig. 2 gezeigten Ausführungsbeispiel nach rechts verschoben ist. Zusätzlich kann das Verriegelungselement 5 zweifarbig ausgestaltet werden, so dass die zweite Farbe erst sichtbar ist, wenn dieses eingerastet und/oder entriegelt ist. In einer vorteilhaften Ausführungsvariante ist der Hebelarm 2 vorgespannt, beispielsweise mittels einer Rückstellfeder, so dass der Hebelarm nach dem Entriegeln selbsttätig in die Zwischenposition geschwenkt wird.

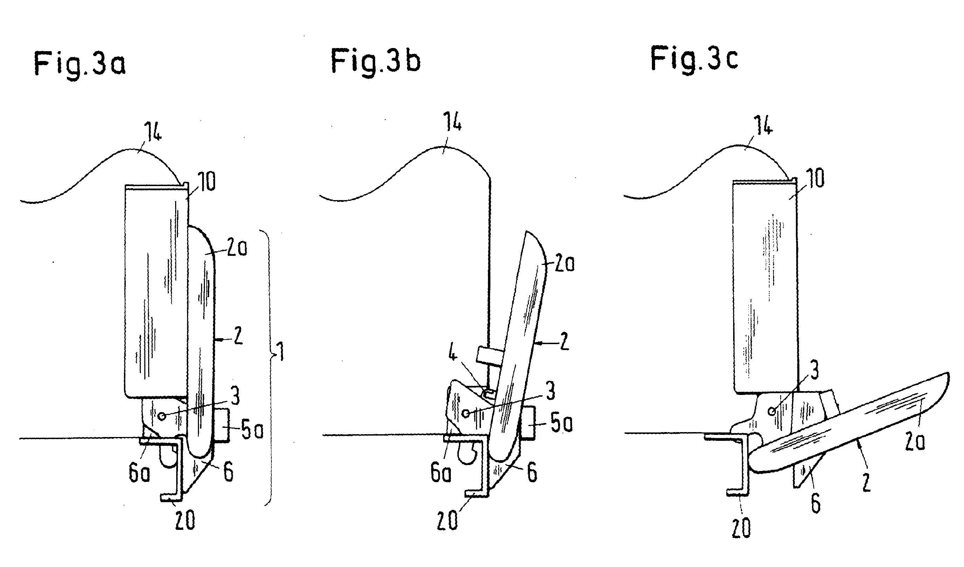

Die Figuren 3a - c zeigen Seitenansichten eines Ausführungsbeispiels einer Vorrichtung zum Einstecken und Ausziehen einer Steckbaugruppe gemäss vorliegender Erfindung mit einem Hebelarm 2 in drei verschiedenen Positionen sowie Ausschnitte aus den zugehörigen Steckbaugruppen. Die in Fig. 3a gezeigte Steckbaugruppe umfasst eine Vorrichtung 1 zum Einstecken und Ausziehen derselben, ein Frontprofil 10, im Folgenden einfach Frontplatte genannt, und eine Leiterplatte 14. Der Hebelarm 2 der Vorrichtung ist mit einem Griffteil 2a ausgestattet, mittels welchem der Hebelarm um eine Achse 3 geschwenkt werden kann. In Fig. 3a ist der Hebelarm in eingeschwenktem Zustand gezeigt, wobei der Griffteil 2a an der Frontplatte 10 anliegt. Der Griffteil kann auch andere Formen als die gezeigte aufweisen, wobei der Griffteil zweckmässigerweise so gestaltet wird, dass das Fassen desselben in eingeschwenktem Zustand des Hebelarms erschwert wird, und/oder dass das Einführen eines Fingers zwischen Griffteil und Frontplatte durch das Anliegen des Griffteils an der Frontplatte erschwert oder verhindert wird.

Weiter umfasst die Vorrichtung im gezeigten Ausführungsbeispiel ein Verriegelungselement, das in Fig. 3a nicht sichtbar ist, um den Hebelarm zu verriegeln und/oder zu sichern, und ein Betätigungselement 5a zum Entriegeln des Hebelarms sowie ein Halteteil 6 zur Halterung des Verriegelungselementes. Fig. 3a zeigt weiter ein Frontprofil 20 eines Baugruppenträgers, in den die Steckbaugruppe eingesetzt ist. Die Vorrichtung 1 zum Einstecken und Ausziehen der Steckbaugruppe ist im unteren Bereich der Frontplatte 10 der Steckbaugruppe angeordnet, derart, dass in eingeschwenktem Zustand des zugehörigen Hebelarms 2 das Frontprofil 20 des Baugruppenträgers in eine Einbuchtung des Hebelarms eingreift, so dass die Steckbaugruppe ohne Ausschwenken desselben nicht herausgezogen werden kann. Der Hebelarm ist im eingeschwenkten Zustand mittels des Verriegelungselementes verriegelt, womit die Steckbaugruppe gegen unbeabsichtigtes Herausziehen oder Lockern gesichert ist.

In einer vorteilhaften Ausführungsvariante umfasst das Halteteil 6 ein in Richtung zur Leiterplatte 14 vorstehendes Befestigungselement 6a, um das Halteteil an der Leiterplatte zu befestigen. Die Achse 3, um welche der Hebelarm 2 schwenkbar ist, wird mit Vorteil als Befestigungsteil ausgebildet, beispielsweise als Schraube, Passschulterschraube, Bolzen oder Niete, mittels welchem das Befestigungselement 6a an der Leiterplatte 14 befestigt werden kann.

In dem in Fig. 3b gezeigten Ausschnitt der Steckbaugruppe wurde die Frontplatte derselben weggelassen, um den gesamten Hebelarm sichtbar zu machen. Der Hebelarm ist in Fig. 3b in einer Zwischenposition gezeigt, in welche dieser nach dem Entriegeln ausgeschwenkt wird, beispielsweise um einen Winkel von 5° bis 20°, vorzugsweise, 8° bis 15°. In einer vorteilhaften Ausführungsvariante ist der Hebelarm 2 vorgespannt, beispielsweise mittels einer Rückstellfeder 4, so dass der Hebelarm nach dem Entriegeln selbsttätig in die Zwischenposition geschwenkt wird. In der gezeigten Zwischenposition ist das dem Griffteil gegenüberliegende Ende des Hebelarms an einem Frontprofil 20 eines Baugruppenträgers abgestützt, während der Griffteile 2a des Hebelarms nun bequem gefasst und anschliessend weiter ausgeschwenkt werden kann, wodurch die Steckbaugruppe aus dem Baugruppenträger gezogen wird und die Steckverbindungen auf der Rückseite der Steckbaugruppe getrennt werden.

In Fig. 3c ist der Hebelarm 2 in ausgeschwenktem Zustand gezeigt. Die Steckverbindungen auf der Rückseite der Steckbaugruppe sind nun getrennt, so dass diese bequem ohne Hilfsmittel ganz aus dem Baugruppenträger herausgezogen werden kann. Umgekehrt wird beim Einsetzen die Steckbaugruppe von Hand in die in Fig. 3c gezeigte Stellung gebracht und durch Einschwenken des Hebelarms 2 ganz in den Baugruppenträger eingeschoben, wobei eine Einbuchtung des Hebelarms am Frontprofil 20 des Baugruppenträgers abgestützt ist, um die Einsteckkräfte der Steckverbindungen auf der Rückseite der Steckbaugruppe zu überwinden.

Ein Ausführungsbeispiel des erfindungsgemässen Verfahrens zum Einstecken und Ausziehen einer Steckbaugruppe mit Frontplatte in beziehungsweise aus einem Baugruppenträger wird an Hand der Figuren 3a - c erläutert. Das Einstecken und Ausziehen der Steckbaugruppe erfolgt im Ausführungsbeispiel mittels einer Vorrichtung umfassend einen schwenkbaren Hebelarm 2 mit Verriegelung. Zum Ausziehen der Steckbaugruppe wird der eingeschwenkte und verriegelte Hebelarm 2, z.B. ein Hebelarm wie er in Fig. 3a gezeigt ist, mittels eines Betätigungselementes 5a, das, wie beispielsweise in Fig. 1 gezeigt, beabstandet vom Hebelarm angeordnet ist, entriegelt und der entriegelte Hebelarm in eine Zwischenposition ausgeschwenkt, insbesondere selbsttätig in eine Zwischenposition ausgeschwenkt. Eine mögliche Zwischenposition ist in Fig. 3b gezeigt. Anschliessen wird der Hebelarm mittels eines Griffteils 2a desselben weiter ausgeschwenkt, wodurch die Steckbaugruppe herausgezogen wird. Fig. 3c zeigt ein mögliches Beispiel eines Hebelarms in ausgeschwenktem Zustand. Zum Einstecken der Steckbaugruppe wird der Hebelarm mit dem Griffteil 2a eingeschwenkt, bis der Griffteil an der Frontplatte 10 anliegt, und der eingeschwenkte Hebelarm selbsttätig verriegelt.

In einer bevorzugten Ausführungsform des Verfahrens wird das Einführen eines Fingers zwischen Griffteil und Frontplatte durch die Ausgestaltung des Griffteils und/oder das Anliegen des Griffteils an der Frontplatte erschwert oder verhindert.

In einer weiteren bevorzugten Ausführungsform des Verfahrens wird beim Verriegeln und/oder beim Entriegeln des Hebelarms 2 ein Schaltelement zur Aktiv-Passiv-Schaltung der Steckbaugruppe betätigt.

Dank der Ausgestaltung des Griffteils des Hebelarms in der Vorrichtung zum Einstecken und Ausziehen einer Steckbaugruppe mit Frontplatte, welcher in eingeschwenktem Zustand an der Frontplatte der Steckbaugruppe anliegt oder in dieser versenkt ist und/oder der beabstandeten Anordnung des Betätigungselementes zum Entriegeln wird eine Trennung des Entriegelungsvorgang vom Ausziehvorgang erreicht. Dadurch wird einer möglichen Beschädigung des Verriegelungselementes des Hebelarms vorgebeugt, wie sie auftreten kann, wenn der Entriegelungsvorgang praktisch ohne Trennung in den Ausziehvorgang übergeht. Zusätzlich vorteilhaft ist, dass, wenn die Aktiv- Passivschaltung oder Stromlos-Schaltung der Steckbaugruppe mit dem Entriegelungsvorgang gekoppelt wird, der minimale zeitliche Abstand zwischen dem Betätigen des Schaltelementes beim Entriegeln und dem Trennen der rückseitigen Steckverbindungen beim Ausziehen der Steckbaugruppe verlängert werden kann.

## Patentansprüche

1. Vorrichtung zum Einstecken und Ausziehen einer Steckbaugruppe mit Frontplatte in beziehungsweise aus einem Baugruppenträger, welche Vorrichtung (1) einen um eine Achse (3) schwenkbaren Hebelarm (2) mit einem Griffteil (2a) zum Schwenken des Hebelarms umfasst sowie ein Verriegelungselement (5) zum Verriegeln des Hebelarms in eingeschwenktem Zustand und ein Betätigungselement (5a), mit welchem der Hebelarm (2) entriegelt werden kann, **dadurch gekennzeichnet, dass** das Betätigungselement (5a) beabstandet vom Hebelarm (2) in Richtung der Schwenkachse (3) angeordnet ist, und dass der Griffteil (2a) derart ausgestaltet ist, dass er im eingeschwenkten Zustand an der Frontplatte (10) der Steckbaugruppe anliegt.

2. Vorrichtung nach Anspruch 1, wobei der Hebelarm (2) nach dem Entriegeln in eine Zwischenposition schwenkbar ist, insbesondere selbsttätig in eine Zwischenposition schwenkbar ist.

3. Vorrichtung nach einem der Ansprüche 1 oder 2 umfassend ein Halteteil (6), insbesondere ein Halteteil zur Halterung des Verriegelungselementes (5) und/oder Betätigungselementes (5a).

4. Vorrichtung nach einem der vorangehenden Ansprüche umfassend ein Schaltelement für eine Aktiv-Passiv-Schaltung der Steckbaugruppe, welches Schaltelement mittels des Verriegelungselementes (5) und/oder Betätigungselementes (5a) betätigbar ist, und welches Schaltelement insbesondere am Halteteil (6) befestigt ist.

5. Ein- und Aushebevorrichtung nach einem der Ansprüche 3 oder 4, wobei am Halteteil (6) ein Zentrierstift zur Zentrierung der Steckbaugruppe beim Einstecken vorgesehen ist.

6. Vorrichtung nach einem der vorangehenden Ansprüche, wobei das Verriegelungselement (5) selbsttätig einrastbar ausgebildet ist, um den Hebelarm (2) im eingeschwenkten Zustand zu sichern.

7. Verfahren zum Einstecken und Ausziehen einer Steckbaugruppe mit Frontplatte in beziehungsweise aus einem Baugruppenträger mittels einer Vorrichtung (1) umfassend einen um eine Achse (3) schwenkbaren Hebelarm (2) mit Verriegelung, in welchem Verfahren
zum Ausziehen der Steckbaugruppe der eingeschwenkte und verriegelte Hebelarm mittels eines Betätigungselementes (5a), das beabstandet vom Hebelarm (2) in Richtung des Schwenkachse (3) angeordnet ist, entriegelt wird;
der entriegelte Hebelarm (2) selbsttätig in eine Zwischenposition ausgeschwenkt wird;
der Hebelarm (2) mittels eines Griffteils (2a) desselben weiter ausgeschwenkt wird, wodurch die Steckbaugruppe herausgezogen wird; zum Einstecken der Steckbaugruppe der Hebelarm (2) mit dem Griffteil (2a) eingeschwenkt wird, bis der Griffteil an der Frontplatte (10) anliegt; und der eingeschwenkte Hebelarm (2) selbsttätig verriegelt wird.

8. Verfahren nach Anspruch 7, wobei das Einführen eines Fingers zwischen Griffteil (2a) und Frontplatte (10) durch die Ausgestaltung des Griffteils und/oder das Anliegen des Griffteils an der Frontplatte erschwert oder verhindert wird.

9. Verfahren nach einem der Ansprüche 7 oder 8, wobei beim Verriegeln und/oder beim Entriegeln des Hebelarms ein Schaltelement zur Aktiv-Passiv-Schaltung der Steckbaugruppe betätigt wird.

10. Steckbaugruppe mit Frontplatte umfassend mindestens eine Vorrichtung (1) nach einem der Ansprüche 1 bis 6 zum Einstecken und Ausziehen der Steckbaugruppe in beziehungsweise aus einem Baugruppenträger und/oder Steckbaugruppe mit Frontplatte zum Ausführen eines Verfahrens nach einem der Ansprüche 7 bis 9.

11. Baugruppenträger umfassend mindestens eine Steckbaugruppe nach Anspruch 10.

## Claims

1. An apparatus for the insertion and withdrawal of a plug-in module with front panel into and out of a module carrier, which apparatus (1) includes a lever arm (2) pivotable about an axis (3) with a handle portion (2a) for the rotation of the lever arm as well as a locking element (5) to lock the lever arm in an inwardly pivoted position and an operating element (5a) to unlock the lever arm (2), **characterized in that** the operating element (5a) is arranged spaced from the lever arm (2) in the direction of the pivot axis (3), and **in that** the handle portion (2a) is designed such that it contacts the front panel of the plug-in module in the inwardly pivoted position.

2. An apparatus according to claim 1, wherein the lever arm (2) is pivotable into an intermediate position after the unlocking, in particular automatically pivotable into an intermediate position.

3. An apparatus according to either of claims 1 or 2 including a holding part (6), in particular a holding part for the holding of the locking element (5) and/or of the operating element (5a).

4. An apparatus according to any one of the preceding claims including a switching element for an active/passive switching of the plug-in module, said switching element being operable by means of the locking element (5) and/or of the operating element (5a), and said switching element being in particular secured on the holding part (6).

5. An apparatus for lifting in and out according to either of claims 3 or 4, wherein a centering pin for the centering of the plug-in module upon insertion, is provided on the holding part (6).

6. An apparatus according to any one of the preceding claims, wherein the lock element (5) is formed to latch automatically, in order to secure the lever arm (2) in the inwardly pivoted position.

7. A method for the insertion and withdrawal of a plug-in module with a front panel into and out of a module carrier respectively by means of an apparatus (1) including a lever arm (2) pivotable about an axis (3) and with a lock, in which method,
for the withdrawal of the plug-in module, the inwardly pivoted and locked lever arm is unlocked by means of an operating element (5a) arranged spaced from the lever arm (2) in the direction of the pivot axis (3);
the unlocked lever arm (2) is outwardly pivoted automatically into an intermediate position;
the lever arm (2) is further outwardly pivoted by means of a handle portion (2a) of the same, whereby the plug-in module is drawn out; the lever arm (2) with the handle portion (2a) is pivoted inwardly for the insertion of the plug-in module, until the handle portion contacts the front panel (10); and
the inwardly pivoted lever (2) arm is automatically locked.

8. A method according to claim 7, wherein the introduction of a finger between the handle portion (2a) and the front panel (10) is made more difficult or hindered through the design of the handle portion and/or the contact of the handle portion at the front panel.

9. A method according to either of claims 7 or 8, wherein a switching element is operated for the active passive switching of the plug-in module during unlocking and/or locking of the lever arm.

10. A plug-in module with front panel including at least one apparatus (1) according to one of the claims 1 to 6 for the insertion and withdrawal of the plug-in module into and out of a module carrier respectively and/or a plug-in module with front panel to carry out a method according to any one of the claims 7 to 9.

11. A module carrier including at least one plug-in module according to claim 10.

## Revendications

1. Dispositif pour l'insertion ou l'extraction d'un module enfichable avec une plaque frontale dans respectivement d'un support de module, ledit dispositif (1) comprenant un bras de levier (2) apte à pivoter autour d'un axe (3) avec une partie de préhension (2a) pour le pivotement du bras de levier ainsi qu'un élément de verrouillage (5) pour le verrouillage du bras de levier à l'état pivoté vers l'intérieur et un élément d'actionnement (5a) au moyen duquel le bras de levier (2) peut être déverrouillé, **caractérisé en ce que** l'élément d'actionnement (5a) est disposé à une distance du bras de levier (2) en direction de l'axe de pivotement (3), et **en ce que** la partie de préhension (2a) est réalisée de façon à s'appliquer à l'état pivoté vers l'intérieur à la plaque frontale (10) du module enfichable.

2. Dispositif selon la revendication 1, où le bras de levier (2), après le déverrouillage, peut être amené à pivoter dans une position intermédiaire, en particulier peut pivoter automatiquement dans une position intermédiaire.

3. Dispositif selon l'une des revendications 1 ou 2, comprenant une partie de support (6), en particulier une partie de support pour la support de l'élément de verrouillage (5) et/ou de l'élément d'actionnement (5a).

4. Dispositif selon l'une des revendications précédentes, comprenant un élément de commutation pour une commutation active-passive du module enfichable, ledit élément de commutation étant actionnable au moyen de l'élément de verrouillage (5) et/ou de l'élément d'actionnement (5a), et ledit élément de commutation étant fixé en particulier à la partie de support (6).

5. Dispositif d'insertion et d'extraction selon l'une des revendications 3 ou 4, où est prévu à la partie de support (6) un goujon de centrage pour le centrage du module enfichable lors de l'insertion.

6. Dispositif selon l'une des revendications précédentes, où l'élément de verrouillage (5) est réalisé pour s'enclencher automatiquement pour assurer le bras de levier (2) à l'état pivoté vers l'intérieur.

7. Procédé d'insertion et d'extraction d'un module enfichable avec une plaque frontale dans respectivement d'un support de module au moyen d'un dispositif comprenant un bras de levier (2) pivotant autour d'un axe (3) avec un verrouillage, procédé dans lequel, pour l'extraction du module enfichable, le bras de levier pivoté vers l'intérieur et verrouillé est déverrouillé au moyen d'un élément d'actionnement (5a) qui est espacé du bras de levier (2) en direction de l'axe de pivotement (3);
le bras de levier déverrouillé (2) est pivoté automatiquement dans une position intermédiaire;
le bras de levier (2) est pivoté plus loin au moyen d'une partie de préhension (2a) de celui-ci moyennant quoi le module enfichable est extrait; pour l'enfichage du module enfichable, le bras de levier (2) est pivoté vers l'intérieur avec la partie de préhension (2a) jusqu'à ce que la partie de préhension s'applique à la plaque frontale (10); et le bras de levier pivoté vers l'intérieur (2) est verrouillé automatiquement.

8. Procédé selon la revendication 7, où l'introduction d'un doigt entre la partie de préhension (2a) et la plaque frontale (10) est rendue difficile ou est empêchée par la configuration de la partie de préhension et/ou l'application de la partie de préhension à la plaque frontale.

9. Procédé selon l'une des revendications 7 ou 8, où lors du verrouillage et/ou du déverrouillage du bras de levier, un élément de commutation pour la commutation active-passive du module enfichable est actionné.

10. Module enfichable avec une plaque frontale comprenant au moins un dispositif (1) selon l'une des revendications 1 à 6 pour l'insertion et l'extraction du module enfichable dans respectivement d'un support de module et/ou module enfichable avec une plaque frontale pour l'exécution d'un procédé selon l'une des revendications 7 à 9.

11. Support de module comprenant au moins un module enfichable selon la revendication 10.
